# EUROPÄISCHE PATENTSCHRIFT

(11) **EP 3 513 250 B1**
(45) Veröffentlichungstag und Bekanntmachung des Hinweises auf die Patenterteilung: **02.11.2022**
(21) Anmeldenummer: 17771401.1
(22) Anmeldetag: 17.09.2017
(51) Int. Cl.: G03F 7/20, C22C 32/00, C22C 47/04

(54) **KOMPONENTE FÜR EINE SPIEGELANORDNUNG FÜR DIE EUV-LITHOGRAPHIE UND VERFAHREN ZUR HERSTELLUNG DERSELBEN**
COMPONENT FOR A MIRROR ARRAY FOR EUV LITHOGRAPHY AND METHOD FOR MANUFACTURING THE SAME
COMPOSANT POUR UN SYSTÈME DE MIROIRS POUR LA LITHOGRAPHIE EUV ET SON PROCÉDÉ DE FABRICATION

(30) Priorität: 16.09.2016 DE 102016217735
(43) Veröffentlichungstag der Anmeldung: 24.07.2019
(73) Patentinhaber: Carl Zeiss SMT GmbH, 73447 Oberkochen (DE)
(72) Erfinder: EVA, Eric, 73434 Aalen (DE)
(74) Vertreter: Werner & ten Brink
(86) Internationale Anmeldenummer: PCT/EP2017/073376
(87) Internationale Veröffentlichungsnummer: WO 2018/050876

(56) Entgegenhaltungen:
- DE-A1-102009 008 706
- DE-A1-102012 200 736
- DE-A1-102013 224 292
- JP-A- 2004 076 043
- KR-A- 20140 068 817
- US-A1- 2007 057 415
- TIZIANI C ET AL: "Processing and mechanical behaviour of a dual scale particle strengthened copper composite", INTERNATIONAL JOURNAL OF MATERIALS RESEARCH, CARL HANSER VERLAG, MUNCHEN, DE, Bd. 97, Nr. 11, 1. November 2006 (2006-11-01), Seiten 1579-1585, XP001519063, ISSN: 1862-5282

## Beschreibung

Die vorliegende Erfindung bezieht sich auf eine Komponente für eine Spiegelanordnung für die EUV-Lithographie sowie auf ein Verfahren zu deren Herstellung.

Um bei der Produktion von beispielsweise Halbleiterbauelementen mit lithographischen Methoden immer feinere Strukturen erzeugen zu können, wird mit immer kurzwelligerem Licht gearbeitet. Arbeitet man im extremen ultravioletten (EUV) Wellenlängenbereich, etwa bei Wellenlängen zwischen ca. 5 nm und 20 nm, lässt sich nicht mehr mit linsenartigen Elementen in Transmission arbeiten, sondern es werden Beleuchtungs- und Projektionsobjektive aus Spiegelelementen mit an die jeweilige Arbeitswellenlänge angepassten hochreflektierenden Beschichtungen aufgebaut.

Die Beleuchtungssysteme von EUV-Lithographievorrichtungen enthalten üblicherweise zwei Facettenspiegel, die jeweils eine Vielzahl von dicht nebeneinander angeordneten Spiegelfacetten umfassen. Um einstellen zu können, aus welchen Richtungen eine Maske mit Strukturen, die auf einen Wafer abgebildet werden sollen, mit Strahlung der Arbeitswellenlänge beleuchtet wird, sind die Spiegelfacetten individuell mit Hilfe von Aktuatoren verstellbar. Die Spiegelfacetten sind dabei sehr dicht auf einer Tragstruktur angeordnet, so dass der für Aktuatoren und Gelenke zur Verfügung stehende Raum knapp ist. Da EUV-Lithographievorrichtungen im Vakuum betrieben werden müssen, kann Wärme, die in den Spiegelfacetten durch Absorption der auftreffenden Strahlung entsteht, nicht über einen Gasstrom abgeführt werden. Die Kühlung muss daher überwiegend über Wärmeleitung erfolgen, was die gelenkige Anbindung der Spiegelfacetten an die Tragstruktur erschwert.

Gattungsgemäße Komponenten für eine Spiegelanordnung für die EUV-Lithographievorrichtung sind beispielsweise aus der DE 10 2013 215 169 A1 bekannt. Gemäß dieser Schrift sind die Verhältnisse beim Feld-Facettenspiegel besonders problematisch, dessen Spiegelfacetten von Spiegelfacetten des Pupillen-Facettenspiegels so auf die Maske abgebildet werden, dass sich die Bilder der Feld-Spiegelfacetten auf der Maske überlagern und diese somit gleichmäßig beleuchten. Um Lichtverluste zu vermeiden, müssen die Spalten zwischen benachbarten Feld-Spiegelfacetten möglichst schmal sein, was zu besonders beengten Raumverhältnissen führt. Die Raumverhältnisse sind deswegen kritisch, weil die Aktuatoren und Gelenke der Feld-Spiegelfacetten aufwendiger als bei den Pupillen-Spiegelfacetten ausgeführt sind, denn die Feld-Spiegelfacetten dürfen sich bei Verkippungen nicht lateral bewegen. Außerdem ist das Problem der Wärmeabfuhr beim Feld-Facettenspiegel gravierender, da sich dieser im Strahlengang vor dem PupillenFacettenspiegel befindet.

Um den hohen Anforderungen an Wärmeleitfähigkeit, im Material erlaubten Spannungen, Steifigkeit und Festigkeit bei Komponenten für Spiegelanordnungen, insbesondere bei Facettenspiegeln in Beleuchtungssystemen von EUV-Lithographievorrichtungen gerecht zur werden, werden sie bisher u.a. aus dispersionsgehärteten Metallen oder ausscheidungsgehärteten Legierungen, bevorzugt Kupfer bzw. Kupferlegierungen, Aluminium bzw. Aluminiumlegierungen oder Kupfer-Aluminiumlegierungen gefertigt. Auch naturharte Legierungen sind geeignet.

Die DE 10 2012 200 736 A1 offenbart eine Spiegelanordnung, insbesondere für den Einsatz in einer mikrolithographischen Projektionsbelichtungsanlage, mit einer Mehrzahl von Einzelspiegeln und einer Mehrzahl von Festkörpergelenken. Die Festkörpergelenke sind als eine Gelenkplatte ausgebildet. Als Material der Gelenkplatte kann z.B. ein Metall mit guter Wärmeleitfähigkeit wie etwa eine Kupferlegierung verwendet werden.

Es hat sich allerdings gezeigt, dass die Komponenten wegen Platzmangels teilweise so dünn dimensioniert sein können, dass ihr Querschnitt in der Größenordnung von der Korngrößen von ausscheidungsgehärteten Legierungen liegt, so dass es lokal dazu kommen kann, dass ein Komponentenquerschnitt von nur noch 1 bis 2 Körnern gebildet wird, was die Langzeitstabilität der Komponente gefährdet und bei der Fertigung nicht zu detektieren ist. Wegen der in der Regel kleineren Korngröße bei dispersionsgehärtetem Metall, z.B. Kupfer ist dieses Risiko geringer. Sie zeigen aber ein schlechteres Kriechverhalten. Außerdem ist die Wahrscheinlichkeit größer, das bei Lötprozessen Lot einlegiert wird oder beim in-situ Reinigen von Spiegelanordnungen mit Wasserstoff, insbesondere atomarem Wasserstoff, dieser in die Komponente eindringt und dort zu Schädigungen führt.

Aus der JP 2004-076043 A ist ein Metall-Keramik-Verbundmaterial für Wärmesenken für Halbleiterkomponente bekannt, bei dem in einer Metallmatrix, die u.a. aus Kupfer oder Aluminium sein kann, Siliziumkarbid-Partikel als Verstärkungsmaterial vorgesehen sind. Auf den Oberflächen der Siliziumkarbid-Partikel sind davon abstehend kurze Kohlenstoffnanoröhrchen angeordnet, so dass sie als Haftvermittler zur Metallmatrix dienen und die Wärmeleitfähigkeit erhöhen.

Weiter beschreibt die DE 10 2009 008 706 A1 die Verwendung von Metallpulver-Verbundmaterialien als Konstruktionswerkstoff für Gehäuse, Chassis, Stative und/oder Module optischer Geräte, wobei das Verbundmaterial zusätzlich nichtmetallische Fasermaterialien aufweist, wie Glasfasern, Karbonfasern und/oder Nanotubus.

Es ist eine Aufgabe der vorliegenden Erfindung, die bekannten Komponenten für Spiegelanordnungen für die EUV-Lithographie zu verbessern.

Diese Aufgabe wird gelöst durch eine Komponente für eine Spiegelanordnung für die EUV-Lithographie, die zumindest teilweise aus einem Verbundmaterial mit einem kupfer- und/ oder aluminiumhaltigen Matrixmaterial und mit Verstärkungsmaterial in Form von Fasern gefertigt ist, wobei das Verbundmaterial zusätzlich Partikel aufweist aus einem oder mehreren der Materialien der Gruppe Graphit, diamantartigem Kohlenstoff und Keramik.

Bei dem Matrixmaterial kann es sich um Kupferlegierungen oder Aluminiumlegierungen, insbesondere um naturharte oder ausscheidungsgehärtete Legierungen handeln. Bevorzugt handelt es sich um Aluminium, besonders bevorzugt um Kupfer.

Es hat sich herausgestellt, dass diese faserverstärkten Verbundmaterialien erlauben, auch schmaldimensionierte Komponenten für Spiegelanordnungen für die EUV-Lithographie bereitzustellen, die sowohl eine hinreichende Wärmeleitfähigkeit als auch eine hinreichende Festigkeit aufweisen. Insbesondere lassen sich bei hinreichender Wärmeleitfähigkeit Komponenten mit hinreichendem Sicherheitsfaktor zwischen in der Komponente auftretenden Spannungen und der Streckgrenze des Materials konstruieren. Ein besonderer Vorteil besteht außerdem darin, dass insbesondere bei sehr dünnen Komponenten oder Komponenten mit sehr dünnen Stellen, die nahe oder im Bereich der Korngrößen des Matrixmaterials liegen, das Risiko eines Bruchs unter Dauerbelastung verringert wird.

Es hat sich außerdem herausgestellt, dass wenn das Verbundmaterial zusätzlich Partikel aufweist aus einem oder mehreren der Materialien der Gruppe Graphit, diamantartigem Kohlenstoff und Keramik, sich die Materialeigenschaften zusätzlich in eine gewünschte Richtung verbessern lassen. So können u.a. die Festigkeit, die Wärmeleitfähigkeit, und die Kriecheigenschaften verbessert werden.

Sowohl als Verstärkungsmaterial als auch als zusätzliche Partikel haben insbesondere die Materialien auf Kohlenstoffbasis den Vorteil, dass im Wesentlichen die Wärmeleitfähigkeit von Kupfer bei höherer mechanischer Festigkeit und besserem Kriechverhalten erhalten werden kann.

In bevorzugten Ausführungsformen weist das Verbundmaterial als Verstärkungsmaterial eines oder mehrere aus der Gruppe Kohlenstoffnanoröhren, Kohlenstofffasern, Mineralfasern, Glasfasern und Keramikfasern auf. Bei den Mineralfasern sind Asbest- oder Wollastonitfasern in Hinblick auf gute Wärmeleitfähigkeit und hohe Festigkeit der Komponente besonders bevorzugt, bei den keramischen Fasern Siliziumkarbidfasern, Fasern aus Mischungen von Aluminiumoxid und Siliziumoxid wie beispielsweise Mullit, oder Fasern aus Boroxid oder Zirkoniumoxid oder aus Carbosilanen. Bei Glasfasern sind insbesondere Fasern aus Quarzglas oder aus dotiertem Quarzglas bevorzugt.

Bei den Komponenten kann es sich um beliebige Bauteile einer Spiegelanordnung handeln, die im weitesten Sinne zur Halterung der Spiegelelemente dienen. Die Halterung kann auch beweglich ausgebildet sein, wie das insbesondere in Facettenspiegeln der Fall sein kann, um die Orientierung einzelner Spiegelfacetten oder Spiegelfacettengruppen umstellen zu können. Bevorzugt ist die Komponente als Bauteil eines Spiegelgelenk ausgebildet, das dadurch eine höhere Lebensdauer aufweisen kann, da das Risiko von Kriechen oder Bruch geringer ist, was auch die Positioniergenauigkeit erhöhen kann.

Insbesondere ist vorteilhaft, wenn das Matrixmaterial, insbesondere eine Kupfer- oder Aluminiummatrix, dispersionsgehärtet ist und dadurch etwa gegenüber einem reinen Matrixmaterial eine weiter erhöhte Festigkeit aufweist.

In bevorzugten Ausführungsformen sind die Fasern aus Verstärkungsmaterial und/oder die Partikel beschichtet. Dadurch kann die Gefahr verringert werden, dass Wasserstoff oder andere reaktive Gase, die während des Betriebs bzw. der Reinigung durch das Matrixmaterial, insbesondere das Kupfermatrixmaterial in die Komponente eindringen könnten, mit dem Verstärkungsmaterial oder dem Partikelmaterial reagieren und zu einer Korrosion der Komponente beitragen. Die Beschichtung kann auch als Haftvermittler zur Kupfermatrix oder einem anderen Matrixmaterial dienen. Vorteilhafterweise sind die Partikel und/oder Fasern mit einem oder mehreren Materialien der Gruppe Edelmetall, Metalloxid, Molybdän und Silizium beschichtet. Als Diffusionsbarriere gegen Wasserstoff haben sich unter anderem Molybdän-/Silizium-Mehrfachbeschichtungen als geeignet erwiesen.

In bevorzugten Ausführungsformen weist die Komponente Verstärkungsfasern auf, deren Anordnung im Matrixmaterial im Wesentlichen der Geometrie der Komponente entspricht. Dadurch kann die Komponente insbesondere in Richtung der im Betrieb in der Komponente wirkenden Kräfte verstärkt werden.

Im Hinblick auf einen Schutz vor Wasserstoffversprödung oder den negativen Einfluss anderer reaktiver Gase, denen die Komponente während des Betriebs oder der Reinigung der EUV-Lithographievorrichtung ausgesetzt sein könnte, ist die Komponente bevorzugt zumindest teilweise beschichtet. Besonders bevorzugt ist sie allseitig beschichtet. Bei massiveren Komponenten können Belüftungslöcher vorgesehen sein, die Wasserstoff, der durch Risse oder Defekte eingedrungen ist, erlauben, aus der Komponente auszutreten. Die Belüftungslöcher können beispielsweise lasergebohrt sein.

Vorteilhafterweise ist die Komponente mit einem oder mehreren Materialien der Gruppe Edelmetall, Metalloxid, Molybdän und Silizium beschichtet, insbesondere bei Verstärkungsmaterial oder zusätzlichen Partikeln auf der Basis von Kohlenstoff wie Graphit, diamantartigem Kohlenstoff oder Kohlenstoffnanoröhren, die von Wasserstoff besonders stark angegriffen werden können. Als Diffusionsbarriere gegen Wasserstoff haben sich unter anderem Molybdän-/Silizium-Mehrfachbeschichtungen als geeignet erwiesen.

Bevorzugt weist die Komponente eine Streckgrenze Rp0,2 von größer 200 N/mm² bei 20°C, bevorzugt von größer 400 N/mm² bei 20°C auf, insbesondere für kupferhaltige Komponenten. Die Streckgrenze Rp0,2 wird auch Dehngrenze oder Elastizitätsgrenze genannt. Sie entspricht der mechanischen Spannung, bei der die auf die Anfangslänge einer Probe bezogene bleibende Dehnung nach Entlastung 0,2% beträgt.

Vorteilhafterweise weist die Komponente eine Wärmeleitfähigkeit von größer 320 W/mK, bevorzugt von größer 370 W/mK auf, insbesondere bei einer Komponente mit Kupfer als Matrixmaterial, die Verstärkungsfasern und/oder Partikel aus Siliziumkarbid, Graphit oder Diamant aufweist. Durch die hohe Wärmeleitfähigkeit ist eine solche Komponente besonders gut für den Einsatz im Vakuum einer EUV-Lithographievorrichtung geeignet.

In einem weiteren Aspekt wird die Aufgabe gelöst durch ein Verfahren zum Herstellen einer Komponente wie beschrieben mit den Schritten:
- Einbringen von Verstärkungsmaterial in das Matrixmaterial;
- Formen der Komponente aus dem Matrixmaterial mit Verstärkungsmaterial;
- Sintern und/oder Verdichten der Form und/oder Endbearbeiten der Komponente,
wobei das Matrixmaterial in Form von frisch reduziertem Metallpulver eingebracht wird oder das Formen und/oder Sintern und/oder das Verdichten in reduzierender Atmosphäre durchgeführt wird.

Durch das Verarbeiten von frisch reduziertem Pulver, insbesondere Aluminium- oder Kupferpulver oder dem Durchführen von einem oder mehreren Herstellungsschritten in reduzierender Atmosphäre kann sichergestellt werden, dass das Material der Komponente möglichst sauerstofffrei ist und resistent gegen Wasserstoffversprödung ist.

Man kann beispielsweise auf pulvermetallurgischer Basis arbeiten oder die Verstärkungsfasern in geschmolzenes Matrixmaterial einbringen.

Optional können zusätzlich zu den Verstärkungsfasern Partikel aus Graphit, diamantartigem Kohlenstoff und/oder Keramik wie etwa aus Siliziumkarbid zugegeben werden. Außerdem kann eine Dispersionshärtung durch Zusatz von beispielsweise feinstverteiltem Aluminiumoxid vorgenommen werden. Ferner können die Fasern aus Verstärkungsmaterial oder die zusätzlichen Partikel vor Einbringen in das Matrixmaterial, insbesondere wenn sie auf Kohlenstoffbasis sind, zum Schutz vor Wasserstoff, beispielsweise durch Galvanisieren oder chemische oder physikalische Gasabscheidung wie etwa Bedampfen oder Sputtern mit Edelmetall, Metalloxid oder auch Mo/Si-Mehrfachschichten beschichtet werden.

Bevorzugt wird ein faserförmiges Vorläufermaterial des Verstärkungsmaterials und/oder zusätzlich Vorläufermaterial für zusätzliche Partikel in das Matrixmaterial eingebracht und reagiert während des Formens und/oder des Sinterns und/oder des Verdichtens das Vorläufermaterial zu Verstärkungsmaterial und/oder zu Partikelmaterial. So können beispielsweise zur Partikelbildung Kohlenstoffverbindungen eingebracht werden, die erst beim Verdichten zu Kohlenstoff in Form von Graphit oder diamantartigem Kohlenstoff insbesondere in reduzierender Atmosphäre karbonisieren. Oder es kann beispielsweise nanodisperses Bor eingebracht werden, das mit im Matrixmaterial vorhandenem Sauerstoff zu Boroxidpartikeln reagiert und so den Sauerstoff bindet. Ebenso können Borfäden eingebracht werden, die zu Boroxidfasern reagieren.

Je nach Wahl des Verstärkungsmaterials und ggf. des Materials der zusätzlichen Partikel sowie je nach Geometrie der herzustellenden Komponente kann das Formen und/oder Sintern und/oder Verdichten mittels Extrudieren, Lasersintern, Plasmasintern, Heißpressen und/oder heißisostatisches Pressen durchgeführt werden.

Je nach Geometrie und geplantem Einsatzort in der Spiegelanordnung kann das Endbearbeiten der Komponente mittels Erodieren, Fräsen, Schleifen, Polieren und/oder Beschichten durchgeführt werden. Das Beschichten kann unter anderem durch Galvanisieren oder chemische oder physikalische Abscheidung aus der Gasphase geschehen.

Die vorliegende Erfindung soll unter Bezugnahme auf ein bevorzugtes Ausführungsbeispiel näher erläutert werden. Dazu zeigen schematisch
- Figur 1: eine EUV-Lithographievorrichtung;
- Figur 2: ein Beleuchtungssystem einer EUV-Lithographievorrichtung;
- Figur 3: eine Detailansicht einer Spiegelanordnung;
- Figur 4: eine erste Ausführungsform einer Komponente;
- Figur 5: eine zweite Ausführungsform einer Komponente; und
- Figur 6: ein Verfahren zur Herstellung einer Komponente.

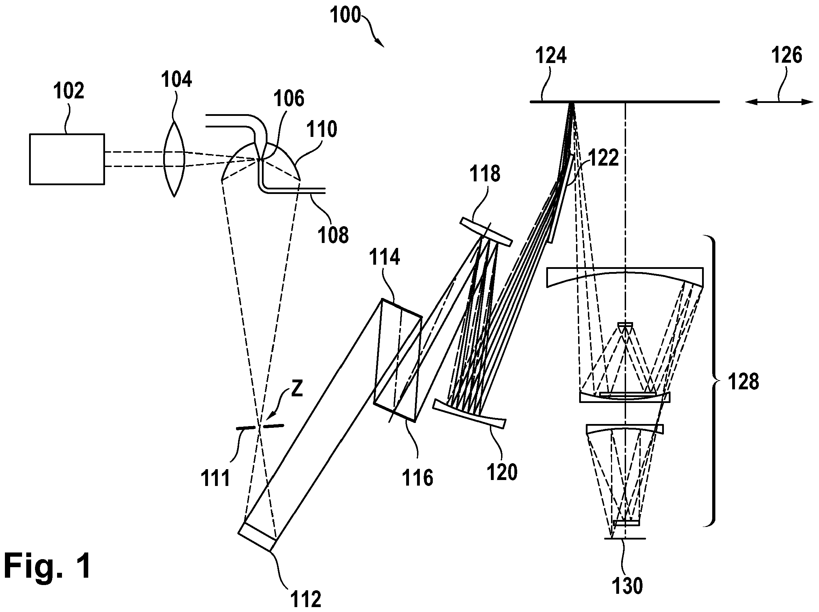

In Figur 1 ist in einer Prinzipansicht eine EUV-Lithographievorrichtung 100 für die Herstellung von beispielsweise mikroelektronischen Bauteilen gezeigt, die in einem Scanmodus entlang einer Scanrichtung 126 mit einer Arbeitswellenlänge im EUV-Bereich betrieben wird und die ein oder mehrere Spiegelanordnungen mit Komponenten aus faserverstärktem Kupfer aufweisen kann. Die in Figur 1 gezeigte EUV-Lithographievorrichtung 100 weist eine punktförmige Plasmastrahlungsquelle auf. Die Strahlung der Laserquelle 102 wird über eine Kondensorlinse 104 auf geeignetes Material gerichtet, das über die Zufuhr 108 eingeleitet wird und zu einem Plasma 106 angeregt wird. Die vom Plasma 106 emittierte Strahlung wird vom Kollektorspiegel 110 auf den Zwischenfokus Z abgebildet. Durch entsprechende Blenden 111 am Zwischenfokus Z wird gewährleistet, dass keine unerwünschte Streustrahlung auf die nachfolgenden Spiegel 112, 114, 116, 118, 120 des Beleuchtungssystems der Projektionsbelichtungsanlage 100 trifft. Der Planspiegel 122 dient zur Faltung des Systems, um Bauräume für mechanische und elektronische Komponenten in der Objektebene, in der die Halterung für das Retikel 124 angeordnet ist, zur Verfügung zu stellen. Im Beleuchtungssystem folgen im vorliegenden Beispiel auf den Spiegel 112 ein Feldfacettenspiegel 114 und ein Pupillenfacettenspiegel 116. Der Feldfacettenspiegel 114 dient dazu, eine Vielzahl von Abbildern der Strahlungsquelle der EUV-Lithographievorrichtung in eine Pupillenebene zu projizieren, in der ein zweiter Facettenspiegel angeordnet ist, der als Pupillenfacettenspiegel 116 dient und die Abbilder der Facetten des Feldfacettenspiegels 114 in der Objektebene überlagert, um eine möglichst homogene Ausleuchtung zu ermöglichen. Die anschließend an die Facettenspiegel 114, 116 angeordneten Spiegel 118 und 120 dienen im Wesentlichen dazu, das Feld in der Objektebene zu formen. In der Objektebene ist ein strukturiertes Retikel 124 angeordnet, dessen Struktur mittels eines Projektionsobjektivs 128 mit im vorliegenden Beispiel sechs Spiegeln auf das zu belichtende Objekt 130, etwa einen Wafer abgebildet wird. Das Retikel 124 ist in der hier als Scanning-System ausgelegten EUV-Lithographievorrichtung 100 in die eingezeichnete Richtung 126 verfahrbar und wird sukzessive abschnittsweise ausgeleuchtet, um die jeweiligen Strukturen des Retikels 124 mit dem Projektionsobjektiv entsprechend auf beispielsweise einen Wafer 130 zu projizieren.

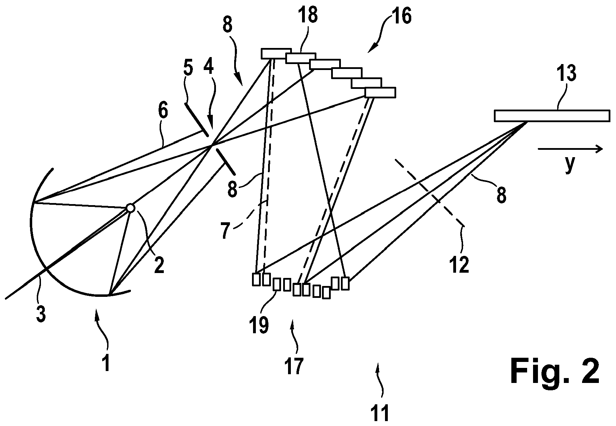

In Figur 2 ist eine Strahlungsquelle in Verbindung mit einem Beleuchtungssystem 11 dargestellt, das Teil einer EUV-Lithographievorrichtung ist. Ein Kollektor 1 ist um eine Lichtquelle angeordnet, die von einem Plasmatröpfchen 2 gebildet wird, die von einem Infrarotlaser 3 angeregt wird. Um im EUV-Wellenlängenbereich Wellenlängen im Bereich um beispielsweise 13,5 nm zu erhalten, kann z.B. Zinn mittels eines bei einer Wellenlänge von 10,6 µm arbeitenden Kohlendioxidlasers zu einem Plasma angeregt werden. Anstelle eines Kohlendioxidlasers können beispielsweise auch Festkörperlaser eingesetzt werden. Auf den Kollektor 1 folgen nach der Blende 5, die einen Teil 6 der emittierten Strahlung aus dem Strahlengang entfernt, am Zwischenfokus 4 eine Feldfacettenspiegelanordnung 16 mit einzelnen Spiegelfacetten 18 und eine Pupillenfacettenspiegelanordnung 17 mit einzelnen Spiegelfacetten 19, wobei die Spiegelanordnungen 16, 17 Komponenten aus faserverstärktem Kupfer aufweisen. Von jeder Feldspiegelfacette 18 wird Strahlung 7, 8 auf jede Pupillenspiegelfacette 19 reflektiert. Bevor die Strahlung auf das in y-Richtung abzuscannende Retikel 13 mit der auf einen Wafer zu projizierenden Struktur trifft, wird sie noch von einem Faltspiegel 12 umgelenkt. Der Faltspiegel 12 hat weniger optische Funktion, er dient vielmehr dazu, den Platzbedarf des Beleuchtungssystems 11 zu optimieren.

Es sei darauf hingewiesen, dass in der EUV-Lithographie verschiedenste Strahlungsquellen eingesetzt werden können, u.a. Plasmaquellen, die etwa auf Laseranregung (LPP-Quellen) oder Gasentladung (DPP-Quellen) basieren können, Synchrotronstrahlungsquellen oder freie Elektronenlaser (FEL). Ferner können die Kollektoren beliebig ausgestaltet sein, u.a. auch als Wolter-Kollektor oder als ellipsoider Kollektor, bevorzugt angepasst an die jeweils verwendete Strahlungsquelle. Außerdem kann auch das Beleuchtungssystem einer EUV-Lithographievorrichtung beliebig ausgestaltet sein und u.a. zusätzlich oder auch anstelle der Facettenspiegel Wabenkondensoren, spekulare Reflektoren, bewegbare optische Komponenten o.a. aufweisen.

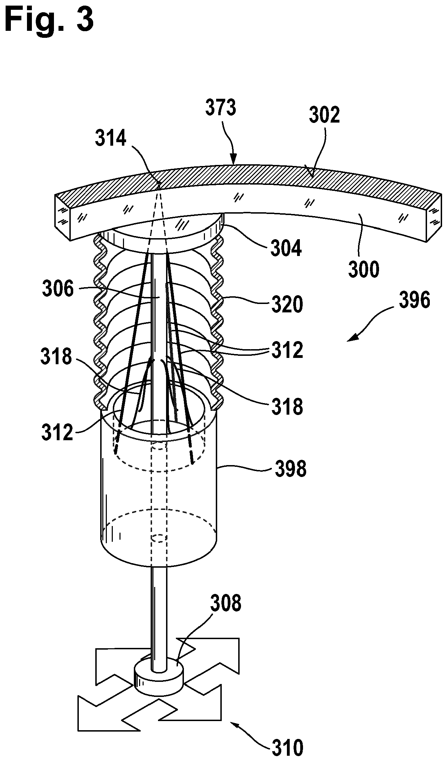

Alle diese Spiegelanordnungen können Komponenten in Form von Halte-, Trage- oder Gelenkelementen aufweisen, bei denen die Anforderungen an Festigkeit und Wärmeleitfähigkeit hoch sind und die aus Komponenten für eine Spiegelanordnung für die EUV-Lithographie gefertigt sein können, die zumindest teilweise aus einem Verbundmaterial mit kupfer- oder aluminiumhaltigen Matrixmaterial und mit Verstärkungsmaterial in Form von Fasern bestehen. Ohne Beschränkung der Allgemeinheit wird im Folgenden die hier vorgeschlagene Komponente am Beispiel eines Festkörpergelenks 396 einer Feldspiegelfacette 373 wie in Figur 3 dargestellt weiter erläutert.

Die Figur 3 zeigt in einer perspektivischen Darstellung, wie eine Feld-Spiegelfacette 373 über ein Festkörpergelenk 396 mit einer Befestigungshülse 398 verbunden ist, die einen ringförmigen Querschnitt hat und starr mit einer hier nicht dargestellten Trägerplatte befestigt ist. Die Befestigungshülsen 398 bilden zusammen mit der Trägerplatte eine Tragstruktur für die Feld-Spiegelfacetten 373, gegenüber der die Feld-Spiegelfacetten 373 verkippbar sind.

Die Feld-Spiegelfacette 373 weist ein Substrat 300 auf, das eine reflektierende Beschichtung 302 trägt. Die reflektierende Beschichtung ist dazu ausgelegt, die Beleuchtungsstrahlung so zu reflektieren, dass mindestens 60% und vorzugsweise mindestens 70% der auftreffenden Strahlung reflektiert wird. Die reflektierende Beschichtung 302 umfasst hierzu im dargestellten Ausführungsbeispiel eine alternierende Abfolge dünner Schichten aus Molybdän und Silizium, die ihre maximale Reflektivität bei quasi-normalem Einfall bei einer Wellenlänge von ca. 13,5 nm hat.

Die Feld-Spiegelfacette 373 wird im dargestellten Ausführungsbeispiel exzentrisch von einem Tragelement 304 getragen, das die Form einer Kreisscheibe hat. An die Unterseite des Tragelements 304 ist mittig ein Betätigungsstab 306 angeformt, der sich durch die Befestigungshülse 398 hindurch erstreckt. An seinem gegenüberliegenden Ende ist an dem Betätigungsstab 306 ein Endstück 308 angeformt, an dem ein nicht dargestellter Aktuator zum Verkippen der Feld-Spiegelfacette 373 angreifen kann. In der Figur 3 ist dies durch einen gekreuzten Doppelpfeil 310 angedeutet.

Das Festkörpergelenk 396 verbindet den Betätigungsstab 306 mit der Befestigungshülse 398. Zu diesem Zweck umfasst das Festkörpergelenk 396 drei um den Betätigungsstab 306 herum angeordnete Gelenkbeine 312, die an einem Ende an der Innenfläche der Befestigungshülse 398 und an dem anderen Ende an dem Tragelement 304 befestigt sind. Der Winkel zwischen benachbarten Gelenkbeinen 312 beträgt dabei jeweils 120°. Würde man die Gelenkbeine 312 virtuell über das Tragelement 304 hinaus verlängern, wie dies in der Figur 3 mit gestrichelten Linien angedeutet ist, so träfen sich die Gelenkbeine 312 in einem Kipppunkt 314 , der zumindest näherungsweise auf der reflektierenden Beschichtung 302 der Feld-Spiegelfacette 373 liegt.

Wird der Betätigungsstab 306 mit Hilfe eines Aktuators ausgelenkt, so wird die Feld-Spiegelfacette 373 um den Kipppunkt 314 herum verschwenkt, wobei sich die Gelenkbeine 312 verbiegen. Die Biegesteifigkeit der Gelenkbeine 312 legt somit den Biegewiderstand fest, der durch den Aktuator überwunden werden muss, um die Feld-Spiegelfacette 373 zu verkippen. Infolge der gleichmäßigen Verteilung der Gelenkbeine 312 um den Betätigungsstab 306 herum ist der Biegewiderstand des Festkörpergelenks 396 annähernd isotrop, so dass das Festkörpergelenk 396 einer Verkippung der Feld-Spiegelfacette 373 um jeder der zwei orthogonalen Kippachsen zumindest annähernd den gleichen Biegewiderstand entgegensetzt.

Zusätzlich zu den Gelenkbeinen 312 erstrecken sich zwischen der Befestigungshülse 398 und dem Betätigungsstab 306 mehrere Wärmeleitfasern 318. Die Wärmeleitfasern 318 haben eine besonders hohe Wärmeleitfähigkeit. Sie haben überdies einen erheblich kleineren Querschnitt und damit auch eine kleinere Biegesteifigkeit als die Gelenkbeine 312, so dass sie einer Auslenkung der Feld-Spiegelfacette 373 nur einen geringen Biegewiderstand entgegensetzen. Wärme, die durch die teilweise Absorption der Beleuchtungsstrahlung in der Feld-Spiegelfacette 373 entsteht, kann somit nicht nur über die Gelenkbeine 312, sondern zu einem Teil auch über die Wärmeleitfasern 318 an die Trägerplatte abgegeben werden. Sind möglichst viele Komponenten wie Tragelement 304, Betätigungsstab 306, Endstück 308, Gelenkbein 312 und Befestigungshülse 398 wie vorgeschlagen zumindest teilweise aus faserverstärktem kupfer- oder aluminiumhaltigen Matrixmaterial, bevorzugt faserverstärktem Aluminium, besonders bevorzugt faserverstärktem Kupfer gefertigt, kann auf Wärmeleitfasern 318 auch verzichtet werden.

Zwischen dem Tragelement 304 und der Befestigungshülse 398 erstreckt sich ferner ein Faltenbalg 320, der den Zwischenraum zwischen der Feld-Spiegelfacette 373 und der Befestigungshülse 398 gegenüber einem Außenraum abschließt. Der Faltenbalg 320 verhindert zum einen, dass kleine Teilchen, die sich infolge mechanischer oder thermischer Belastung von Teilen des Festkörpergelenks 396 oder der Wärmeleitfasern 318 lösen, in den Außenraum gelangen und die Funktion des Beleuchtungssystems beeinträchtigen, indem sie sich z.B. auf Spiegeloberflächen absetzen. Zusätzlich stellt der Faltenbalg 320 sicher, dass sich die Feld-Spiegelfacette 373nicht um die Längsachse des Faltenbalgs 320 dreht.

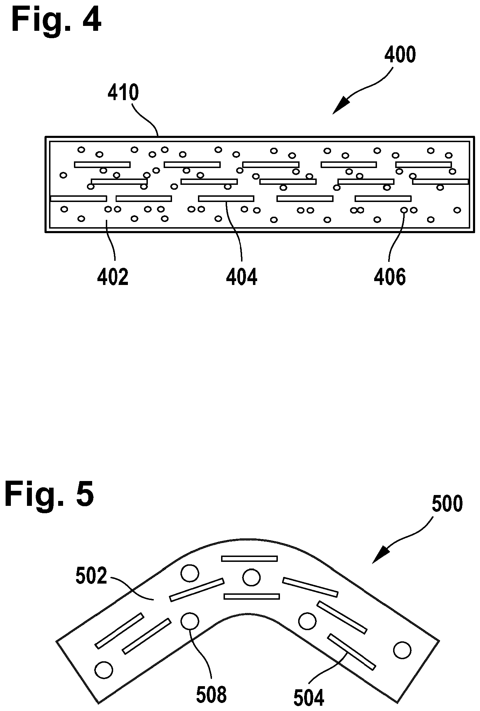

In Figur 4 ist schematisch eine Komponente für eine Spiegelanordnung für die EUV-Lithographie dargestellt, die im hier vorliegenden Beispiel zumindest teilweise aus einem Verbundmaterial mit Kupfer als Matrixmaterial und mit Verstärkungsmaterial in Form von Fasern gefertigt ist, die im vorliegenden Beispiel als Bauteil 400 eines Spiegelgelenks ausgebildet ist. Sie könnte etwa als Gelenkbein 312 wie in Figur 3 dargestellt ausgebildet sein.

Im in Figur 4 dargestellten Beispiel weist das Bauteil 400 im Matrixmaterial 402 aus Kupfer Verstärkungsfasern 404 auf. Die Verstärkungsfasern können aus einem oder mehreren Materialien der Gruppe Kohlenstoffnanoröhren, Kohlenstofffasern, Mineralfasern, Glasfasern und Keramikfasern sein. Bei den Mineralfasern sind Asbest- oder Wollastonitfasern besonders bevorzugt, bei den keramischen Fasern Siliziumkarbidfasern, Fasern aus Mischungen von Aluminiumoxid und Siliziumoxid wie beispielsweise Mullit, oder Fasern aus Boroxid oder Zirkoniumoxid oder aus Carbosilanen. Bei Glasfasern sind insbesondere Fasern aus Quarzglas oder aus dotiertem Quarzglas bevorzugt. Die genannten Materialien sind teilweise eher als Kurzfasern wie die Kohlenstoffnanoröhrchen oder die natürlich vorkommenden Mineralfasern erhältlich. Die synthetisch hergestellten Fasern aus insbesondere Glas, Kohlenstoff oder Siliziumkarbid sind in quasi beliebiger Länge erhältlich. Bei faserverstärktem Aluminium kann ein E-Modul im Bereich von etwa 170 GPa bis 220 GPa, bei faserverstärktem Kupfer sogar im Bereich von etwa 230 GPa bis 280 GPa erreicht werden.

Vor dem Einbringen in das Matrixmaterial 402 können die Verstärkungsfasern 404 zuvor beschichtet werden, zum Beispiel mit einem oder mehreren Materialien der Gruppe Edelmetall, Metalloxid, Molybdän und Silizium. Bevorzugt werden sie mit Gold, Platin, Palladium, Titan, einem Metalloxid oder einer Mehrfachbeschichtung aus alternierenden Molybdän- und Siliziumschichten beschichtet. Insbesondere bei Fasern auf Kohlenstoffbasis ist dies ein guter Schutz gegen Wasserstoff, der in das Matrixkupfer eindringen und zu Versprödung des Bauteils führen könnte. Bei insbesondere keramischen Fasern oder Glasfasern kann die Beschichtung die Funktion eines Haftvermittlers zwischen Faser und Matrix übernehmen und so zu einem besseren Übertrag der auf das Bauteil wirkenden Kräfte auf die Verstärkungsfasern beitragen, was zu einer erhöhten Festigkeit führen kann. Das Beschichten kann durch übliche Verfahren der chemischen oder physikalischen Gasphasenabscheidung oder auch galvanisch erfolgen.

Im in Figur 4 dargestellten Beispiel ist das Matrixmaterial 402 aus Kupfer mittels Dispersoide 406 aus beispielsweise Aluminiumoxid zusätzlich gehärtet. In Varianten kann als Matrixmaterial auch dispersionsgehärtetes Aluminium eingesetzt werden. Aber auch naturharte oder ausscheidungsgehärtete Aluminium- oder Kupferlegierungen können eingesetzt werden. In Bezug auf Kupferlegierungen sind beispielsweise CuMg0,1, CuMg0,3, CuMg0,4, CuMg0,5, CuMg2,5, CuFe2P, CuCr, CuZr, CuCr1Zr, CuCrAgFeTiSi , CuBe2 geeignet.

Als zusätzlicher Schutz gegen reaktive Gase wie etwa Wasserstoff, der bei der Spiegelreinigung eingesetzt wird, ist das Bauteil 400 beschichtet und zwar hier mit einer allseitigen Beschichtung 410 aus zum Beispiel einem oder mehreren Materialien der Gruppe Edelmetall, Metalloxid, Molybdän und Silizium. Bevorzugt wird es mit Gold, Platin, Palladium, Titan, einem Metalloxid oder einer Mehrfachbeschichtung aus alternierenden Molybdän- und Siliziumschichten beschichtet. Auch diese Beschichtung kann durch übliche Verfahren der chemischen oder physikalischen Gasphasenabscheidung erfolgen, insbesondere für Molybdän-/Silizium-Mehrfachbeschichtungen. Ansonsten wird eine galvanische Beschichtung bevorzugt. Je nach dem wie das Bauteil im Spiegelgelenk oder der Spiegelanordnung verbaut wird, kann es auch ausreichen, nur Teile dessen Oberfläche zu beschichten.

Im in Figur 4 dargestellten Beispiel entspricht die Anordnung der Verstärkungsfasern 404 im Matrixmaterial 402 im Wesentlichen der Geometrie des Bauteils 400. Die Fasern 404 sind in Längsrichtung des Bauteils 400 ausgerichtet.

Auch im in Figur 5 dargestellten Beispiel entspricht die Anordnung der Verstärkungsfasern 504 im Matrixmaterial 502 im Wesentlichen der Geometrie des Bauteils 500. Das Bauteil 500 ist gebogen und auch die Ausrichtung der Fasern 504 folgt im Wesentlichen dieser Biegung. Je länger die Fasern 504 sind, desto einfacher ist es, sie auch entsprechend komplexeren Geometrien mit beispielsweise mehreren Biegungen anzuordnen. Das in Verbindung mit dem in Figur 4 gezeigten Beispiel zu den Verstärkungsfasern Erläuterte gilt ebenso für die Verstärkungsfasern 504. Das Matrixmaterial weist Aluminium oder Kupfer auf, insbesondere kann es aus Kupfer oder Aluminium sein. Das Matrixmaterial kann außerdem dispersionsgehärtet sein.

Im in Figur 5 dargestellten Beispiel weist das Bauteil 500 zusätzlich Partikel 508 auf aus einem oder mehreren der Materialien der Gruppe Graphit, diamantartigem Kohlenstoff und Keramik. Dadurch lassen sich die Festigkeit und die Kriecheigenschaften und insbesondere mit Partikeln aus Graphit oder bevorzugt diamantartigem Kohlenstoff auch die Wärmeleitfähigkeit erhöhen.

So wie bereits im Zusammenhang mit Figur 4 für die Verstärkungsfasern erläutert, können auch die Partikel 508 beschichtet sein, um sie vor reaktiven Gasen zu schützen oder die Haftung mit dem Kupfer des Matrixmaterials 502 zu verbessern. Sie können ebenfalls zum Beispiel mit einem oder mehreren Materialien der Gruppe Edelmetall, Metalloxid, Molybdän und Silizium beschichtet sein. Bevorzugt werden sie mit Gold, Platin, Palladium, Titan, einem Metalloxid oder einer Mehrfachbeschichtung aus alternierenden Molybdän- und Siliziumschichten beschichtet. Das Beschichten kann durch übliche Verfahren der chemischen oder physikalischen Gasphasenabscheidung oder auch galvanisch erfolgen.

Die hier beispielhaft dargestellten Bauteile 400, 500 auf der Basis einer faserverstärkten Kupfermatrix weisen eine Streckgrenze Rp0,2 von größer 400 N/mm² bei 20°C auf, so dass auch Beanspruchungen, die beispielsweise in Halte-, Trage- oder Gelenkelementen von Spiegelanordnungen für die EUV-Lithographie auftreten, nicht zu plastischen Verformungen führen.

Die hier dargestellten Bauteile 400, 500 weisen außerdem eine Wärmeleitfähigkeit von größer 320 W/mK auf. Dabei ist der thermische Ausdehnungskoeffizient geringer als bei Kupfer, was zur Präzision der Spiegelanordnungen für die EUV-Lithographie beiträgt, in denen solche Bauteile eingesetzt werden. Unter Verwendung von Kohlenstoffnanoröhrchen, Kohlenstofffasern oder auch zusätzlichen Partikeln aus Graphit oder diamantähnlichen Kohlenstoff können auch Wärmeleitfähigkeiten von 370 W/mK und deutlich darüber erreicht werden. Mittels der hier vorgestellten Bauteile lässt sich auch im in einer EUV-Lithographie herrschenden Vakuum in wesentlichen Umfang Wärme von den Spiegeln zu entfernteren Wärmesenken abführen.

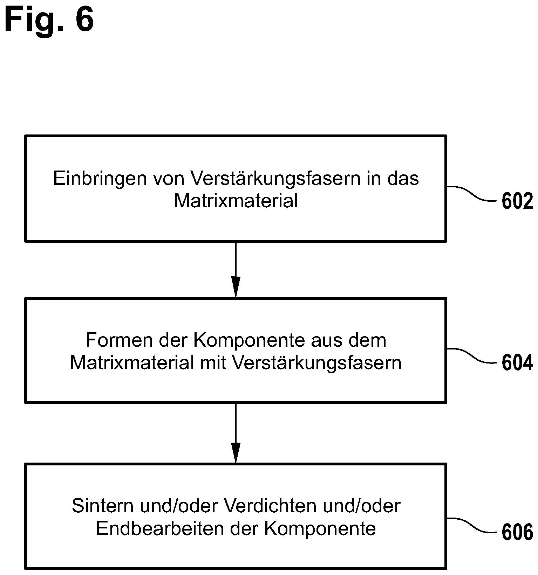

Ein Verfahren zum Herstellen einer zuvor beschriebenen Komponente ist schematisch in Figur 6 dargestellt. Es weist folgende Schritte auf:
- Einbringen von Verstärkungsmaterial in das Matrixmaterial (Schritt 602);
- Formen der Komponente aus dem Matrixmaterial mit Verstärkungsmaterial (Schritt 604);
- Sintern und/oder Verdichten der Form und/oder Endbearbeiten der Komponente (Schritt 606).

In Hinblick auf eine für den Einsatz in der EUV-Lithographie wichtige Resistenz gegen Wasserstoffversprödung ist von Bedeutung, dass das Matrixmaterial in Form von frisch reduziertem Metallpulver eingebracht wird oder das Formen und/oder das Sintern und/oder das Verdichten in reduzierender Atmosphäre durchgeführt wird. Auf diese Weise kann auch ein möglichst sauerstofffreies Material erhalten werden. Es können auch beide Maßnahmen kombiniert werden. Bei dem Pulver handelt es sich um Kupferlegierungen oder Aluminiumlegierungen in Pulverform. Bevorzugt handelt es sich um Aluminiumpulver, besonders bevorzugt um Kupferpulver.

Man kann beispielsweise auf pulvermetallurgischer Basis arbeiten oder die Verstärkungsfasern in geschmolzenes Matrixmaterial einbringen.

In Varianten wird ein faserförmiges Vorläufermaterial des Verstärkungsmaterials und/oder zusätzlich Vorläufermaterial für zusätzliche Partikel in das Matrixmaterial eingebracht und reagiert während des Formens und/oder des Sinterns und/oder des Verdichtens das Vorläufermaterial zu Verstärkungsmaterial und/oder zu Partikelmaterial. So können beispielsweise zur Partikelbildung Kohlenstoffverbindungen eingebracht werden, die erst beim Verdichten, insbesondere in reduzierender Atmosphäre, zu Kohlenstoff in Form von Graphit oder diamantartigem Kohlenstoff karbonisieren. Oder es kann beispielsweise nanodisperses Bor eingebracht werden, das mit im Matrixmaterial vorhandenem Sauerstoff zu Boroxidpartikeln reagiert und so den Sauerstoff bindet. Ebenso können Borfäden eingebracht werden, die zu Boroxidfasern reagieren.

Je nach Wahl des Verstärkungsmaterials und ggf. des Materials der zusätzlichen Partikel sowie je nach Geometrie der herzustellenden Komponente kann das Formen und/oder Sintern und/oder Verdichten mittels Extrudieren, Lasersintern, Plasmasintern, Heißpressen und/oder heißisostatischem Pressen durchgeführt werden. So können insbesondere eher stangenförmige Komponenten extrudiert werden. Dies hat auch bei insbesondere kürzeren Verstärkungsfasern den Effekt, dass der Extrusionsprozess zu einer groben Ausrichtung der Fasern in Extrusionsrichtung führen kann. Komponenten mit eher komplexen und feinteiligen Geometrien können auch mit Hilfe von Lasersintern oder Spark-Plasmasintern bearbeitet werden. Für flächigere Geometrien hat sich das Verdichten durch Heißpressen bewährt.

Für das Verdichten allgemein bzw. Nachverdichten von beispielsweise Extrudaten ist das heißisostatische Pressen von Vorteil. Es erlaubt die Fertigung einer großen Vielfalt von Komponenten in endkonturnahen Geometrien oder sogar Endkonturformen, so dass sich der Aufwand für das Endbearbeiten mittels beispielsweise Erodieren, Fräsen, Schleifen und/ oder Polieren möglichst gering halten lassen kann. Die Mischung aus Verstärkungsfasern und ggf. Partikeln oder Vorläufermaterial mit Matrixmaterial kann u.a. als Pulver in eine eingekapselte Form gegeben werden, die anschließend einem isostatischen Druck von ca. 1 bar und gleichzeitig einer Temperatur von ca. 1000°C bis 1100°C ausgesetzt wird. Unter Verwendung von Quarzglas oder dotiertem Quarzglas können auch Verbundwerkstoffe mit Glasfaserverstärkung in der Matrix mittels heißisostatischem Pressen verarbeitet werden.

Im Hinblick auf den Einsatz in einer EUV-Lithographievorrichtung kann vorteilhafterweise als letzter Herstellungsschritt eine möglichste allseitige Beschichtung der Komponente als Schutz gegen reaktive Gase wie etwa Wasserstoff mit Edelmetall, wie etwa Gold, Platin, Titan oder Palladium, einem oder mehreren Metalloxiden und/oder einer Mo/Si-Mehrfachbeschichtung durch übliche Verfahren der chemischen oder physikalischen Gasphasenabscheidung oder bevorzugt galvanisch erfolgen.

Optional können zusätzlich zu den Verstärkungsfasern Partikel aus Graphit, diamantartigem Kohlenstoff und/oder Keramik wie etwa aus Siliziumkarbid zugegeben werden. Außerdem kann eine Dispersionshärtung durch Zusatz von beispielsweise feinstverteiltem Aluminiumoxid vorgenommen werden. Ferner können die Fasern aus Verstärkungsmaterial oder die zusätzlichen Partikel vor Einbringen in das Matrixmaterial, insbesondere wenn sie auf Kohlenstoffbasis sind zum Schutz vor Wasserstoff, beispielsweise durch Galvanisieren oder chemische oder physikalische Gasabscheidung wie etwa Bedampfen oder Sputtern mit Edelmetall, Metalloxid oder auch einer Mo/Si-Mehrfachbeschichtung beschichtet werden.

### Bezugszeichen

- 1: Kollektor
- 2: Plasmatröpfchen
- 3: Infrarot-Laser
- 4: Zwischenfokus
- 5: Blende
- 6: Strahlung
- 7: Strahlung
- 8: Strahlung
- 11: Beleuchtungssystem
- 12: Faltspiegel
- 13: Retikel
- 16: Feldfacettenspiegelanordnung
- 17: Pupillenfacettenspiegelanordnung
- 18: Feldfacetten
- 19: Pupillenfacetten
- 100: EUV-Lithographievorrichtung
- 102: Laserquelle
- 104: Kondensorlinse
- 106: Plasma
- 108: Zufuhr
- 110: Kollektorspiegel
- 111: Blende
- 112: Spiegel
- 114: Feldfacettenspiegel
- 116: Pupillenfacettenspiegel
- 118: Spiegel
- 120: Spiegel
- 122: Planspiegel
- 124: Retikel
- 126: Scan-Richtung
- 128: Projektionsobjektiv
- 130: Wafer
- 300: Substrat
- 302: reflektierende Beschichtung
- 304: Tragelement
- 306: Betätigungsstab
- 308: Endstück
- 310: Doppelpfeil
- 312: Gelenkbein
- 314: Kipppunkt
- 318: Wärmeleitfasern
- 320: Faltenbalg
- 373: Feld-Spiegelfacette
- 396: Festkörpergelenk
- 398: Befestigungshülse
- 400: Bauteil
- 402: Matrixmaterial
- 404: Verstärkungsfaser
- 406: Dispersoid
- 410: Beschichtung
- 500: Bauteil
- 502: Matrixmaterial
- 504: Verstärkungsfaser
- 508: Partikel
- 602: Schritt
- 604: Schritt
- 606: Schritt
- Z: Zwischenfokus

## Patentansprüche

1. Komponente für eine Spiegelanordnung für die EUV-Lithographie, **dadurch gekennzeichnet, dass** sie zumindest teilweise aus einem Verbundmaterial mit einem kupfer- und/oder aluminiumhaltigem Matrixmaterial (402, 502) und mit Verstärkungsmaterial in Form von Fasern (404, 504) gefertigt ist, wobei das Verbundmaterial Partikel (508) aufweist aus einem oder mehreren der Materialien der Gruppe Graphit, diamantartigem Kohlenstoff und Keramik.

2. Komponente nach Anspruch 1, **dadurch gekennzeichnet, dass** das Verbundmaterial als Verstärkungsmaterial (404, 504) eines oder mehrere aus der Gruppe Kohlenstoffnanoröhren, Kohlenstofffaser, Mineralfasern, Glasfasern und Keramikfasern aufweist.

3. Komponente nach Anspruch 1 oder 2, **dadurch gekennzeichnet, dass** sie als Bauteil (400, 500) eines Spiegelgelenks ausgebildet ist.

4. Komponente nach einem der Ansprüche 1 bis 3, **dadurch gekennzeichnet, dass** das Matrixmaterial (502, 402) dispersionsgehärtet ist.

5. Komponente nach einem der Ansprüche 1 bis 4, **dadurch gekennzeichnet, dass** die Partikel (508) und/oder Fasern (404, 504) aus Verstärkungsmaterial beschichtet sind.

6. Komponente nach Anspruch 5, **dadurch gekennzeichnet, dass** die Partikel (508) und/oder Fasern (404, 504) mit einem oder mehreren Materialien der Gruppe Edelmetall, Metalloxid, Molybdän und Silizium beschichtet sind.

7. Komponente nach einem der Ansprüche 1 bis 6, **dadurch gekennzeichnet, dass** sie Verstärkungsfasern (504) aufweist, deren Anordnung im Matrixmaterial (502) im Wesentlichen der Geometrie der Komponente (500) entspricht.

8. Komponente nach einem der Ansprüche 1 bis 7, **dadurch gekennzeichnet, dass** sie zumindest teilweise beschichtet ist.

9. Komponente nach Anspruch 8, **dadurch gekennzeichnet, dass** sie mit einem oder mehreren Materialien (410) der Gruppe Edelmetall, Metalloxid, Molybdän und Silizium beschichtet ist.

10. Komponente nach einem der Ansprüche 1 bis 9, **dadurch gekennzeichnet, dass** sie eine Streckgrenze Rp0,2 von größer 200 N/mm² bei 20°C aufweist.

11. Komponente nach einem der Ansprüche 1 bis 10, **dadurch gekennzeichnet, dass** sie eine Wärmeleitfähigkeit von größer 320 W/mK aufweist.

12. Verfahren zum Herstellen einer Komponente gemäß einem der Ansprüche 1 bis 11, mit den Schritten:
- Einbringen von Verstärkungsmaterial in das Matrixmaterial;
- Formen der Komponente aus dem Matrixmaterial mit Verstärkungsmaterial;
- Sintern und/oder Verdichten der Form und/oder Endbearbeiten der Komponente,
wobei das Matrixmaterial in Form von frisch reduziertem Pulver eingebracht wird oder das Formen und/oder das Sintern und/oder das Verdichten in reduzierender Atmosphäre durchgeführt wird.

13. Verfahren nach Anspruch 12, **dadurch gekennzeichnet, dass** ein faserförmiges Vorläufermaterial des Verstärkungsmaterials und/oder zusätzlich Vorläufermaterial von Partikeln in das Matrixmaterial eingebracht und während des Formens und/oder des Sinterns und/oder des Verdichtens das Vorläufermaterial zu Verstärkungsmaterial und/oder zu Partikelmaterial reagiert.

14. Verfahren nach Anspruch 12 oder 13, **dadurch gekennzeichnet, dass** das Formen und/oder Sintern und/oder Verdichten mittels Extrudieren, Lasersintern, Plasmasintern, Heißpressen und/oder heißisostatisches Pressen durchgeführt wird.

15. Verfahren einem der Ansprüche 12 bis 14, **dadurch gekennzeichnet, dass** das Endbearbeiten mittels Erodieren, Fräsen, Schleifen, Polieren und/oder Beschichten durchgeführt wird.

## Claims

1. Component for a mirror array for EUV lithography, **characterized in that** it is produced at least partly from a composite material comprising a copper- and/or aluminium-containing matrix material (402, 502) and comprising a reinforcing material in the form of fibres (404, 504), wherein the composite material comprises particles (508) composed of one or more of the materials from the group graphite, diamond-like carbon and ceramic.

2. Component according to Claim 1, **characterized in that** the composite material comprises as reinforcing material (404, 504) one or more from the group carbon nanotubes, carbon fibre, mineral fibres, glass fibres and ceramic fibres.

3. Component according to Claim 1 or 2, **characterized in that** it is configured as a structural part (400, 500) of a mirror joint.

4. Component according to any of Claims 1 to 3, **characterized in that** the matrix material (502, 402) is dispersion-hardened.

5. Component according to any of Claims 1 to 4, **characterized in that** the particles (508) and/or fibres (404, 504) composed of reinforcing material are coated.

6. Component according to Claim 5, **characterized in that** the particles (508) and/or fibres (404, 504) are coated with one or more materials from the group high-grade metal, metal oxide, molybdenum and silicon.

7. Component according to any of Claims 1 to 6, **characterized in that** it comprises reinforcing fibres (504) whose arrangement in the matrix material (502) substantially corresponds to the geometry of the component (500).

8. Component according to any of Claims 1 to 7, **characterized in that** it is at least partly coated.

9. Component according to Claim 8, **characterized in that** it is coated with one or more materials (410) from the group high-grade metal, metal oxide, molybdenum and silicon.

10. Component according to any of Claims 1 to 9, **characterized in that** it has a yield point Rp0.2 of greater than 200 N/mm² at 20°C.

11. Component according to any of Claims 1 to 10, **characterized in that** it has a thermal conductivity of greater than 320 W/mK.

12. Method for producing a component according to any of Claims 1 to 11, comprising the following steps:
- introducing reinforcing material into the matrix material;
- shaping the component from the matrix material with reinforcing material;
- sintering and/or compacting the shape of the component and/or finally processing the latter,
wherein the matrix material is introduced in the form of freshly reduced powder or the shaping and/or the sintering and/or the compacting are/is carried out in a reducing atmosphere.

13. Method according to Claim 12, **characterized in that** a fibrous precursor material of the reinforcing material and/or in addition precursor material of particles are/is introduced into the matrix material and, during the shaping and/or the sintering and/or the compacting, the precursor material reacts to form reinforcing material and/or to form particle material.

14. Method according to Claim 12 or 13, **characterized in that** the shaping and/or sintering and/or compacting are/is carried out by means of extrusion, laser sintering, plasma sintering, hot pressing and/or hot isostatic pressing.

15. Method according to any of Claims 12 to 14, **characterized in that** the final processing is carried out by means of erosion, milling, grinding, polishing and/or coating.

## Revendications

1. Composant pour un agencement de miroirs pour la lithographie EUV, **caractérisé en ce qu'**il est fabriqué au moins partiellement à partir d'un matériau composite comprenant un matériau de matrice (402, 502) contenant du cuivre et/ou de l'aluminium et un matériau de renforcement sous la forme de fibres (404, 504), le matériau composite comprenant des particules (508) d'un ou plusieurs des matériaux du groupe constitué par le graphite, le carbone de type diamant et la céramique.

2. Composant selon la revendication 1, **caractérisé en ce que** le matériau composite comprend, en tant que matériau de renforcement (404, 504), un ou plusieurs du groupe constitué par les nanotubes de carbone, les fibres de carbone, les fibres minérales, les fibres de verre et les fibres de céramique.

3. Composant selon la revendication 1 ou 2, **caractérisé en ce qu'**il est configuré sous forme d'élément (400, 500) d'une articulation de miroir.

4. Composant selon l'une quelconque des revendications 1 à 3, **caractérisé en ce que** le matériau de matrice (502, 402) est durci par dispersion.

5. Composant selon l'une quelconque des revendications 1 à 4, **caractérisé en ce que** les particules (508) et/ou les fibres (404, 504) de matériau de renforcement sont revêtues.

6. Composant selon la revendication 5, **caractérisé en ce que** les particules (508) et/ou les fibres (404, 504) sont revêtues d'un ou de plusieurs matériaux du groupe constitué par un métal noble, un oxyde métallique, le molybdène et le silicium.

7. Composant selon l'une quelconque des revendications 1 à 6, **caractérisé en ce qu'**il comprend des fibres de renforcement (504), dont l'agencement dans le matériau de matrice (502) correspond essentiellement à la géométrie du composant (500).

8. Composant selon l'une quelconque des revendications 1 à 7, **caractérisé en ce qu'**il est au moins partiellement revêtu.

9. Composant selon la revendication 8, **caractérisé en ce qu'**il est revêtu d'un ou de plusieurs matériaux (410) du groupe constitué par un métal noble, un oxyde métallique, le molybdène et le silicium.

10. Composant selon l'une quelconque des revendications 1 à 9, **caractérisé en ce qu'**il présente une limite d'élasticité Rp0,2 supérieure à 200 N/mm² à 20 °C.

11. Composant selon l'une quelconque des revendications 1 à 10, **caractérisé en ce qu'**il présente une conductivité thermique supérieure à 320 W/mK.

12. Procédé de fabrication d'un composant selon l'une quelconque des revendications 1 à 11, comprenant les étapes suivantes :
- l'introduction de matériau de renforcement dans le matériau de matrice ;
- le moulage du composant à partir du matériau de matrice avec le matériau de renforcement ;
- le frittage et/ou le compactage du moule et/ou la finition du composant, le matériau de matrice étant introduit sous forme de poudre fraîchement réduite ou le moulage et/ou le frittage et/ou le compactage étant effectués dans une atmosphère réductrice.

13. Procédé selon la revendication 12, **caractérisé en ce qu'**un matériau précurseur fibreux du matériau de renforcement et/ou en outre un matériau précurseur de particules est introduit dans le matériau de matrice et, pendant le moulage et/ou le frittage et/ou le compactage, le matériau précurseur réagit pour former le matériau de renforcement et/ou le matériau particulaire.

14. Procédé selon la revendication 12 ou 13, **caractérisé en ce que** le moulage et/ou le frittage et/ ou le compactage sont effectués par extrusion, frittage par laser, frittage par plasma, pressage à chaud et/ou pressage isostatique à chaud.

15. Procédé selon l'une quelconque des revendications 12 à 14, **caractérisé en ce que** la finition est effectuée par érosion, fraisage, meulage, polissage et/ ou revêtement.
